# EUROPÄISCHE PATENTSCHRIFT

(11) **EP 1 189 974 B1**
(45) Veröffentlichungstag und Bekanntmachung des Hinweises auf die Patenterteilung: **21.05.2003**
(21) Anmeldenummer: 01931357.6
(22) Anmeldetag: 09.03.2001
(51) Int. Cl.: C08G 73/22, G03F 7/038

(54) **POLYBENZOXAZOL-VORSTUFEN**
POLYBENZOXAZOLE PRECURSORS
PRECURSEURS DE POLYBENZOXAZOLE

(30) Priorität: 10.03.2000 DE 10011604
(43) Veröffentlichungstag der Anmeldung: 27.03.2002
(73) Patentinhaber: Infineon Technologies AG, 81669 München (DE)
(72) Erfinder: HAUSSMANN, Joerg, 85356 Freising (DE); MAIER, Gerhard, 80807 München (DE); SCHMID, Günter, 91334 Hemhofen (DE); SEZI, Recai, 91341 Röttenbach (DE)
(74) Vertreter: Kottmann, Heinz Dieter, Dipl.-Ing.
(86) Internationale Anmeldenummer: DE0100907
(87) Internationale Veröffentlichungsnummer: WO01066619

(56) Entgegenhaltungen:
- EP-A- 0 023 662
- EP-A- 0 905 169
- EP-A- 0 905 170
- DE-A- 3 716 629

## Beschreibung

Die Erfindung betrifft neue Polybenzoxazol-Vorstufen sowie diese Vorstufen enthaltende Resistlösungen.

In der Mikroelektronik werden hochwärmebeständige Polymere als Schutz- und Isolierschichten benötigt. Derartige Polymere können als Dielektrikum zwischen zwei Metallebenen eingesetzt werden, beispielsweise bei Multi-Chip-Modulen sowie Speicher- und Logikchips, oder als Pufferschicht ("Buffercoat") zwischen dem Chip und seinem Gehäuse. Einige dieser Polymere, beispielsweise Vorstufen aromatischer Polyimide (PI) und Polybenzoxazole (PBO), zeigen eine gute Löslichkeit in organischen Lösemitteln sowie gute Filmbildungseigenschaften und können mittels kostengünstiger Schleudertechnik auf die elektronischen Bauteile aufgebracht werden. Die Vorstufen werden dann durch eine Temperaturbehandlung cyclisiert, d.h. in das entsprechende Polymer übergeführt, und erhalten damit ihre endgültigen Eigenschaften.

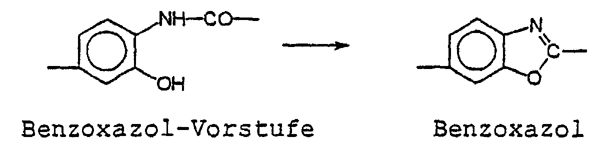

Bei der Cyclisierung verschwinden die polaren, hydrophilen Gruppierungen der PBO-Vorstufe (OH, NH und CO), die sonst die dielektrischen Eigenschaften und die Wasseraufnahme negativ beeinflussen würden. Dies ist beispielsweise ein wesentlicher Vorteil von Polybenzoxazolen gegenüber Polyimiden und insbesondere gegenüber Hydroxypolyimiden. Die Cyclisierung ist aber nicht nur für die guten dielektrischen Eigenschaften und die geringe Wasseraufnahme des Endproduktes wichtig, sondern auch für dessen hohe Temperaturstabilität.

Die Anforderungen an das cyclisierte Endprodukt sind sehr hoch. So ist beispielsweise neben einer möglichst niedrigen Dielektrizitätskonstante auch eine hohe thermische Stabilität erforderlich.

Polyimide und Polybenzoxazole haben gegenüber vielen anderen hochtemperaturstabilen Polymeren folgende Vorteile:
- Sie können - im Vergleich zum cyclisierten Endprodukt - als lösliche Vorstufe auf ein Substrat aufgebracht und anschließend auf dem Substrat cyclisiert werden, wobei die Löslichkeit und damit die Sensibilität gegenüber Lösemitteln und anderen Prozesschemikalien stark abnimmt. Aus diesem Grunde ist beispielsweise die Verarbeitung von vorcyclisierten Polybenzoxazolen schwierig.
- Durch den Zusatz von geeigneten photoaktiven Komponenten zu den Vorstufen können photosensitive Zusammensetzungen hergestellt werden, wodurch eine kostengünstige direkte Strukturierung des Dielektrikums möglich wird. Polybenzoxazole haben gegenüber Polyimiden den weiteren Vorteil, dass sie im positiven Modus strukturierbar und wässrig-alkalisch entwickelbar sind (siehe EP-PS 0 023 662, EP-PS 0 264 678 und EP-PS 0 291 779). Hierzu müssen die verwendeten PBO-Vorstufen im - vorzugsweise metallionenfreien - alkalischen Entwickler löslich sein.
- Benzocyclobuten (BCB), das in ähnlicher Weise verarbeitet und negativ strukturiert werden kann, hat eine wesentlich geringere Temperaturstabilität als Polyimid und Polybenzoxazol.

Beim Einsatz von Polymeren der genannten Art als Dielektrikum zwischen metallischen Leiterbahnen ist es sehr wichtig, dass das Metall bei erhöhter Temperatur, d.h. bei einer Temperatur > 300°C, nicht durch das Dielektrikum diffundiert. Viele Metalle, insbesondere Aluminium, das derzeit am meisten verwendete Metall, diffundieren aber bei hohen Temperaturen durch das Dielektrikum. Aus diesem Grunde wird das Metall mit einer Sperrschicht, beispielsweise aus Titannitrid oder einer Kombination von Titan und Titannitrid, versehen, welche die Diffusion des Metalls in das Dielektrikum verhindert. Die Verwendung einer zusätzlichen Schicht erfordert jedoch einen deutlich höheren Kosten- und auch Zeitaufwand.

Polybenzoxazol-Vorstufen, die auf Substraten cyclisierbar sind und eine gute Temperaturstabilität zeigen, sind beispielsweise aus EP-PS 0 023 662, EP-PS 0 264 678, EP-PS 0 291 779, EP-OS 0 905 169, EP-OS 0 905 170 und DE-PS 37 16 629 bekannt. Hinweise auf die Diffusion von Metallen in den daraus hergestellten Polymeren nach der Cyclisierung auf einem Substrat gibt es aber nicht (siehe EP-PS 0 264 678 und EP-OS 0 317 942).

Aufgabe der Erfindung ist es, Polybenzoxazol-Vorstufen bereitzustellen, die mittels Schleudertechnik verarbeitet werden können, auf Substraten problemlos cyclisierbar sind und nach der Cyclisierung eine hohe Temperaturstabilität aufweisen. Insbesondere sollen diese Vorstufen bzw. die daraus hergestellten Polybenzoxazole eine erhöhte Resistenz gegenüber der Diffusion von Metallen besitzen.

Dies wird erfindungsgemäß durch Polybenzoxazol-Vorstufen erreicht, die eine der folgenden Partialstrukturen enthalten: 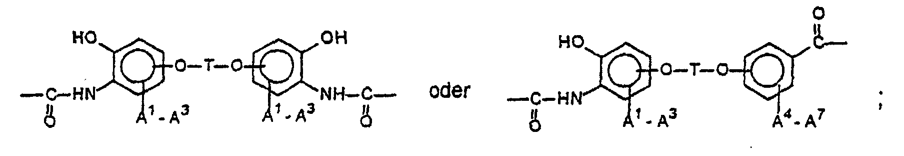 dabei gilt Folgendes:
A¹ bis A⁷ sind - unabhängig voneinander - H, F, CH₃, CF₃, OCH₃ oder OCF₃;
T ist einer der folgenden Reste: 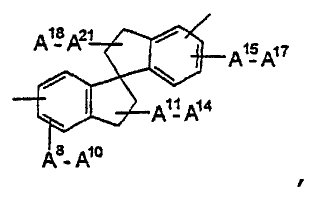 wobei A⁸ bis A²¹ - unabhängig voneinander - H, F, CH₃, CF₃, OCH₃ oder OCF₃ sind; 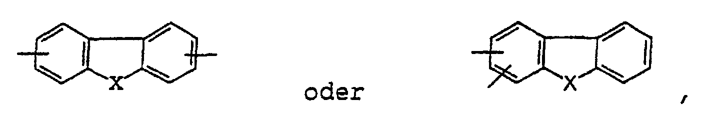 wobei X die Bedeutung CH₂, CF₂, C(CH₃)₂, C(CF₃)₂, C(OCH₃)₂, C(OCF₃)₂, C(CH₃) (C₆H₅), C(C₆H₅)₂, O, N-H, N-CH₃ oder N-C₆H₅ hat; 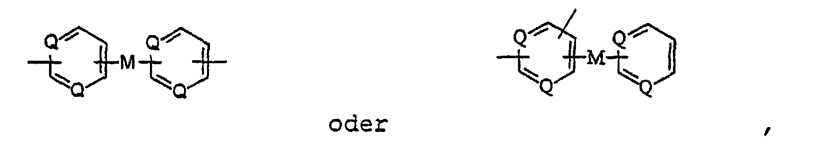 mit M = 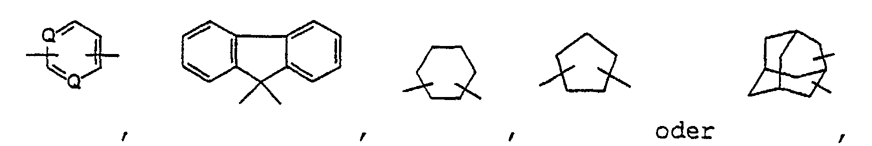 wobei Q jeweils C-H, C-F, C-CH₃, C-CF₃, C-OCH₃, C-OCF₃ oder N ist;
T und M können - unabhängig voneinander - auch einer der folgenden Reste sein: 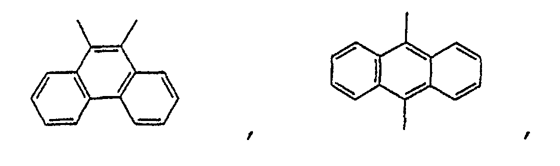 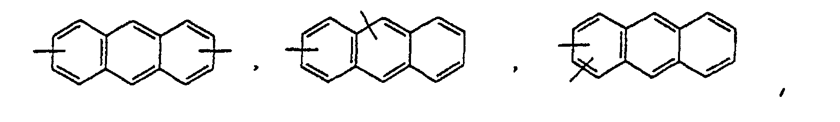 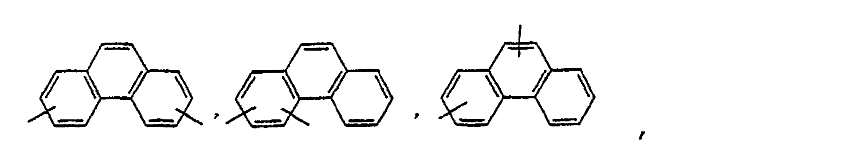 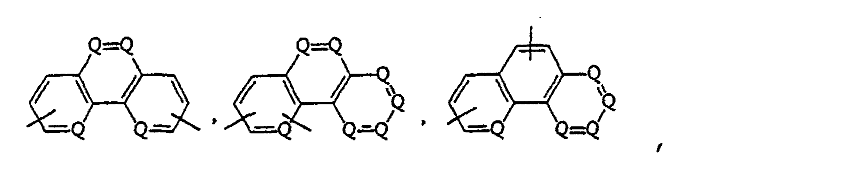 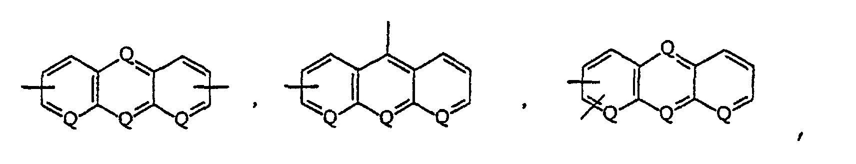 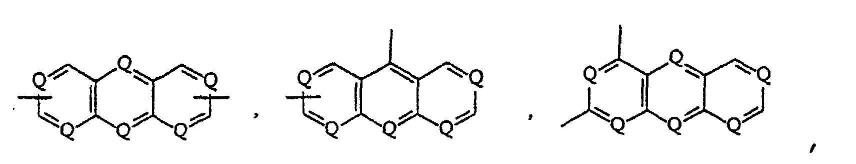 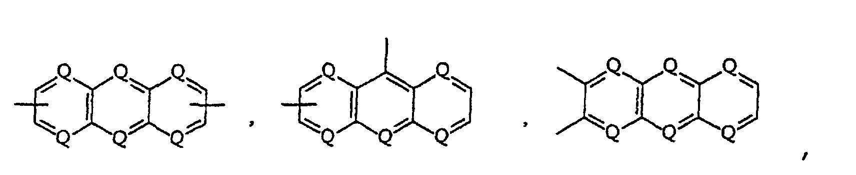 wobei Q wie vorstehend definiert ist, mindestens ein Q die Bedeutung N hat und maximal zwei N-Atome pro Ring vorhanden sein dürfen.

Dielektrika, die aus derartigen Polybenzoxazol-Vorstufen hergestellt werden, zeigen insbesondere eine deutlich verringerte Aluminiumdiffusion. Dadurch wird eine zusätzliche Sperrschicht überflüssig.

Die Metalldiffusion kann dann noch weiter verringert werden, wenn in die Vorstufen Moleküle eingebaut werden, welche Acetylengruppen enthalten. Die Acetylengruppen können dabei in der Hauptkette, als Endgruppe oder als Seitengruppe vorhanden sein. Vorzugsweise liegt den Acetylengruppen eine der folgenden Verbindungen zugrunde:

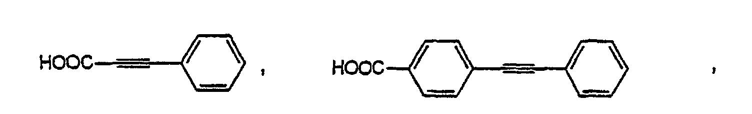

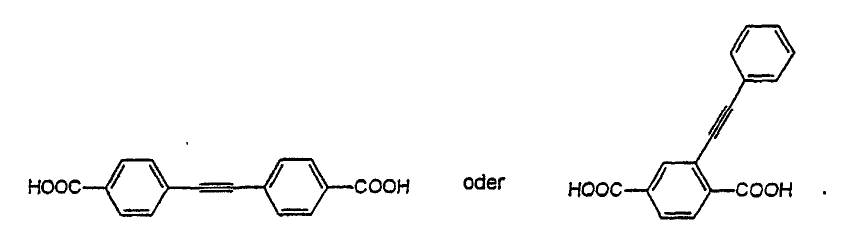

Polybenzoxazol-Vorstufen der vorstehend angegebenen Struktur werden durch Umsetzung von entsprechenden Bis-o-aminophenolen bzw. o-Aminophenolcarbonsäuren, wobei jeweils eine oder mehrere dieser Verbindungen eingesetzt werden können, mit einer oder mehreren geeigneten Dicarbonsäuren oder Dicarbonsäurederivaten, insbesondere aktive Ester und Chloride, hergestellt. Dabei werden das Bis-o-aminophenol bzw. die o-Aminophenolcarbonsäure und die Dicarbonsäure oder das Dicarbonsäurederivat in einem organischen Lösemittel bei einer Temperatur von -20 bis 150°C zur Reaktion gebracht, das Polymer wird dann durch Zutropfen der Reaktionslösung zu einem geeigneten Fällungsmittel ausgefällt. Das ausgefallene Polymer ist bereits nach der Filtration und der Trocknung einsatzbereit. Vor dem Ausfällen des Polymers können dessen Aminoendgruppen mit einem Dicarbonsäureanhydrid oder einem Monocarbonsäurechlorid bzw. -ester verkappt, d.h. blockiert werden. Die o-Aminophenolcarbonsäuren können auch alleine, d.h. ohne eine Dicarbonsäure, zur Reaktion gebracht werden.

Die zur Herstellung der Polybenzoxazol-Vorstufen nach der Erfindung eingesetzten Bis-o-aminophenole und o-Aminophenolcarbonsäuren weisen folgende Struktur auf:

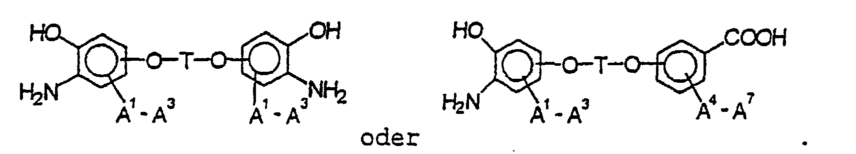

Diese Verbindungen sind Gegenstand der gleichzeitig eingereichten deutschen Patentanmeldung: Akt.Z. ..... - "Bis-o-aminophenole und o-Aminophenolcarbonsäuren" (GR 00 P 8529 DE).
Die Charakterisierung "A¹-A³", "A⁴-A⁷", "A⁸-A¹⁰", "A¹¹-A¹⁴", "A¹⁵-A¹⁷" und "A¹⁸-A²¹" in den Strukturformeln bedeutet, dass die Phenylgruppen bzw. die cyclischen Gruppierungen Reste A¹, A² und A³ bzw. A⁴, A⁵, A⁶ und A⁷ bzw. A⁸, A⁹ und A¹⁰ bzw. A¹¹, A¹², A¹³ und A¹⁴ bzw. A¹⁵, A¹⁶ und A¹⁷ bzw. A¹⁸, A¹⁹, A²⁰ und A²¹ aufweisen.

Beispiele für derartige Bis-o-aminophenole und o-Aminophenolcarbonsäuren sind:
9,9-Bis{4-[(4-amino-3-hydroxy)-phenoxy]-phenyl}-fluoren 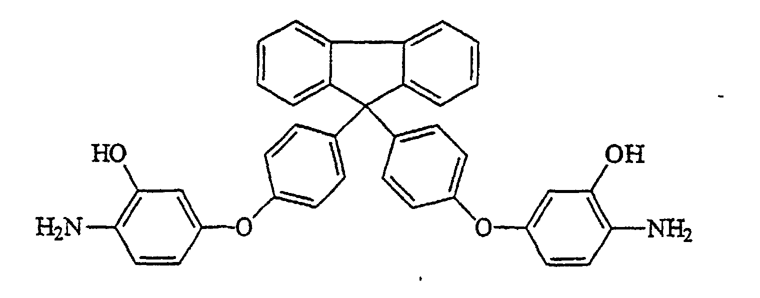
9,10-Bis{4-[(4-amino-3-hydroxy)-phenoxy]-phenyl}-anthracen 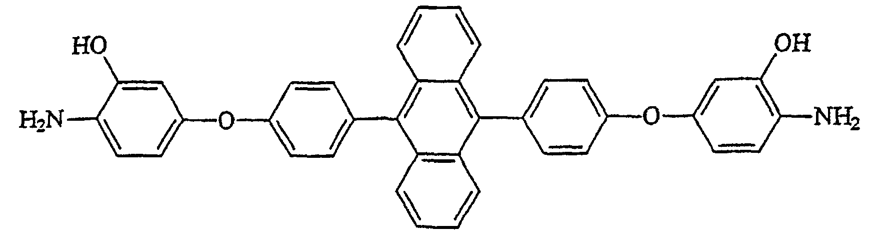
6, 6' -Bis [(4-amino-3-hydroxy)-phenoxy]-5,5'-dimethyl-3, 3,3',3'-tetramethyl-1,1'-spiro-bis(indan) 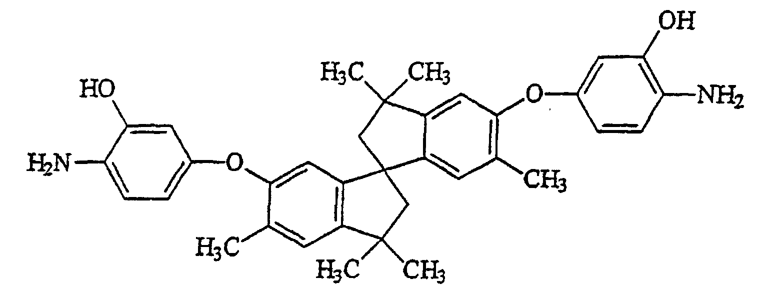
4,7-Bis[(4-amino-3-hydroxy)-phenoxy]-1,10-phenanthrolin 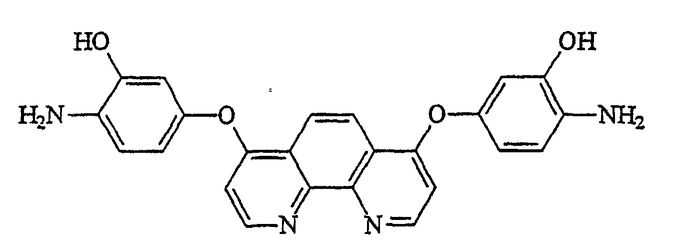
9-{4-[(4-Amino-3-hydroxy)-phenoxy]-phenyl}-9-{4-[(2-trifluormethyl-4-carboxy)-phenoxy]-phenyl}-fluoren 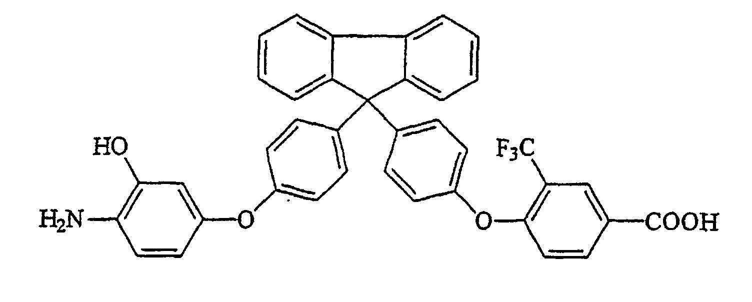
9-{4-[(4-Amino-3-hydroxy)-phenoxy]-phenyl}-10-{4-[(4-carboxy)-phenoxy]-phenyl}-anthracen 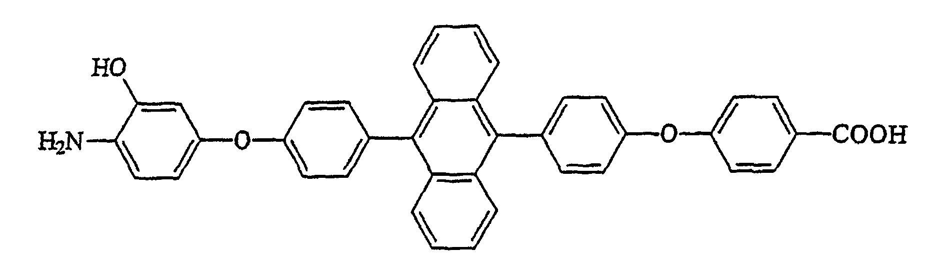
6- [(4-Amino-3-hydroxy)-phenoxy]-6' - [(4-carboxy)-phenoxy]-5,5'-dimethyl-3,3,3',3'-tetramethyl-1,1'-spiro-bis(indan) 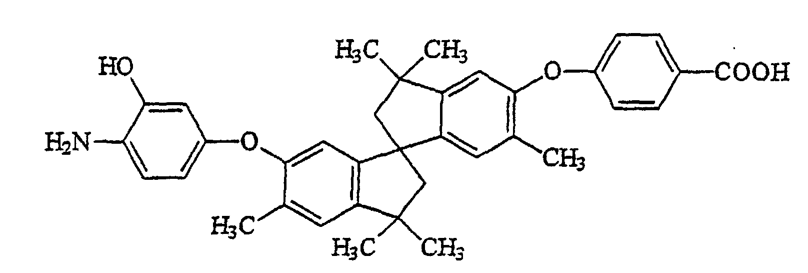
4-[(4-Amino-3-hydroxy)-phenoxy]-7-[(4-carboxy)-phenoxy]-1,10-phenanthrolin

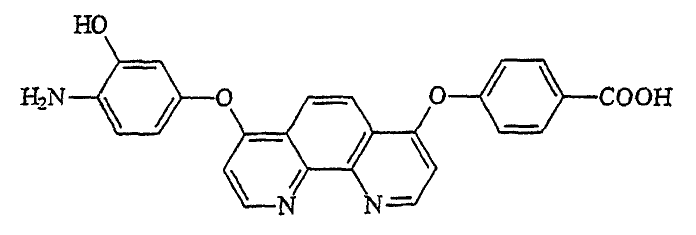

Für die Herstellung der Vorstufen sind Dicarbonsäuren wie 4, 4'-Oxybisbenzoesäure, 2,2-Bis (4-carboxyphenyl)-perfluorpropan und Isophthalsäure besonders geeignet. Prinzipiell können aber alle Dicarbonsäuren verwendet werden, die bis zu drei aromatische Kerne haben. Werden bei der Polymerisation Dicarbonsäurechloride verwendet, so ist der Einsatz eines basischen Säurefängers von Vorteil. Als derartiger Säurefänger dient vorzugsweise Pyridin, Triethylamin, Diazabicyclooctan und Polyvinylpyridin. Es können aber auch andere basische Säurefänger eingesetzt werden, wobei insbesondere solche bevorzugt werden, die im für die Synthese verwendeten Lösemittel, beispielsweise N-Methylpyrrolidon, und in Wasser oder Wasser/Alkohol-Gemischen (Fällungsmittel) gut löslich sind, und auch solche, die im Lösemittel vollkommen unlöslich sind, beispielsweise vernetztes Polyvinylpyridin.

Besonders geeignete Lösemittel für die Polymersynthese sind Dimethylacetamid, γ-Butyrolacton und N-Methylpyrrolidon. Prinzipiell kann jedoch jedes Lösemittel verwendet werden, in dem die Ausgangskomponenten gut löslich sind. Besonders geeignete Fällungsmittel sind Wasser und Gemische von Wasser mit verschiedenen Alkoholen, beispielsweise Ethanol und Isopropanol.

Die Polymer-Vorstufen nach der Erfindung sind in vielen organischen Lösemitteln, wie Aceton, Cyclohexanon, Diethylenglykolmono- bzw. -diethylether, N-Methylpyrrolidon, γ-Butyrolacton, Ethyllactat, Tetrahydrofuran und Essigsäureethylester, sowie in metallionenfreien wässrig-alkalischen Entwicklern gut löslich und lassen sich mittels Schleudertechnik problemlos verarbeiten. Nach der Cyclisierung auf dem Substrat zeigen die dabei erhaltenen Polybenzoxazole eine - im Vergleich zu bekannten Materialien - deutlich reduzierte Aluminiumdiffusion und eine hohe Temperaturstabilität.

Die Polymer-Vorstufen nach der Erfindung sind mit Diazoketonen verträglich und eignen sich deshalb vorteilhaft für Photoresistlösungen, die - gelöst in einem Lösemittel - eine Polybenzoxazol-Vorstufe und eine photoaktive Komponente auf Diazoketonbasis aufweisen. Derartige photoaktive Zusammensetzungen zeigen überraschenderweise eine hohe Auflösung und eine sehr gute Filmqualität. In den Photoresistlösungen liegt das Gewichtsverhältnis von Polybenzoxazol-Vorstufe zu Diazochinon vorteilhaft zwischen 1:20 und 20:1, vorzugsweise zwischen 1:10 und 10:1.

Die den Polymer-Vorstufen nach der Erfindung entsprechenden Polybenzoxazole weisen eine der folgenden Partialstrukturen auf: 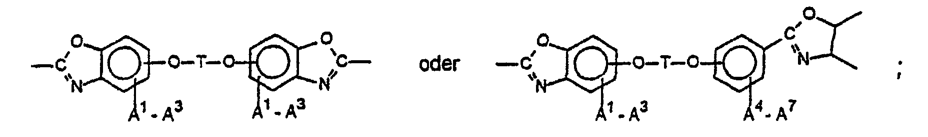 A¹ bis A⁷ und T haben dabei die vorstehend angegebene Bedeutung.

Anhand von Ausführungsbeispielen soll die Erfindung noch näher erläutert werden.

### Beispiel 1

### Herstellung eines Bis-o-aminophenols: 9, 9-Bis{4-[(4-amino-3-hydroxy)-phenoxy]-phenyl}-fluoren

100,0 g 9,9-Bis(4-hydroxy-phenyl)-fluoren (0,285 mol) und 142,5 g 3-Fluor-6-nitro-benzyloxy-phenol (0,576 mol) werden in 1050 ml Dimethylformamid gelöst. Anschließend wird mit 200,0 g K₂CO₃ (1,447 mol) versetzt und unter ständigem Rühren 3 h auf 135°C erhitzt. Nach Beendigung der Reaktion wird auf Raumtemperatur abgekühlt und die Mischung unter Rühren in 2,5 1 Eiswasser gegossen. Der dabei ausfallende gelbe Feststoff wird über einen Büchnertrichter abfiltriert, je einmal mit verdünntem Eisessig und Wasser gewaschen und anschließend in einem Vakuumschrank unter Stickstoff bei 50°C/50 mbar getrocknet.

Zur Reinigung wird das Rohprodukt in der Siedehitze in 800 ml Tetrahydrofuran gelöst und mit 800 ml Petroleumbenzin (Siedebereich 60 bis 80°C) versetzt. Zum Kristallisieren wird 12 h bei 4°C gelagert, anschließend wird über einen Büchnertrichter abfiltriert und der weiße Feststoff im Vakuumschrank unter Stickstoff bei 50°C/50 mbar getrocknet.

70,0 g des auf diese Weise hergestellten 9,9-Bis{4-[(3-benzyloxy-4-nitro)-phenoxy]-phenyl}-fluoren (0,087 mol) werden in 700 ml Tetrahydrofuran gelöst, die Lösung wird mit 7,0 g Palladium auf Aktivkohle versetzt und die Suspension in einem Autoklaven bei Raumtemperatur mit Wasserstoff bei einem Druck von 2 bar hydriert; die Reaktion ist nach 24 h beendet. Die Suspension wird dann über einen Büchnertrichter abfiltriert. Von der dabei erhaltenen roten Lösung wird mittels eines Rotationsverdampfers das Lösemittel vollständig entfernt.

Zur Reinigung wird das Rohprodukt in der Siedehitze in 500 ml Tetrahydrofuran gelöst und mit 150 ml Petroleumbenzin (Siedebereich 60 bis 80°C) versetzt. Zum Kristallisieren wird 12 h bei 4°C gelagert, anschließend wird über einen Büchnertrichter abfiltriert und der schwach gelbe Feststoff in einem Vakuumschrank unter Stickstoff bei 50°C/50 mbar getrocknet.

### Beispiel 2

### Herstellung einer PBO-Vorstufe

56,46 g entsprechend Beispiel 1 hergestelltes 9,9-Bis-{4-[(4-amino-3-hydroxy)-phenoxy]-phenyl}-fluoren (0,1 mol) werden in 300 ml destilliertem N-Methylpyrrolidon gelöst. Zu dieser Lösung wird bei 10°C unter Rühren eine Lösung von 20,3 g Terephthalsäuredichlorid (0,1 mol) in 150 ml γ-Butyrolacton getropft und die Reaktionslösung 16 h gerührt. Danach wird zur Reaktionslösung bei Raumtemperatur langsam eine Lösung von 17,4 g Pyridin (0,22 mol) in 80 ml γ-Butyrolacton getropft und die erhaltene Reaktionslösung 2 h bei Raumtemperatur gerührt. Das entstandene Polymer wird durch Zutropfen der Reaktionslösung zu einem Gemisch von Isopropanol und Wasser (1:3) ausgefällt, dreimal mit frischem Fällungsmittel gewaschen und in einem Vakuumofen 72 h bei 50°C/10 mbar getrocknet.

Die auf diese Weise hergestellte PBO-Vorstufe ist in Lösemitteln wie N-Methylpyrrolidon, γ-Butyrolacton, Aceton, Tetrahydrofuran, Cyclopentanon, Diethylenglykolmonoethylether, Ethyllactat und Ethanol sowie in kommerziell erhältlichen metallionenfreien wässrig-alkalischen Entwicklern, wie NMD-W (Tokyo Ohka), gut löslich.

### Beispiel 3

### Bestimmung der Aluminiumdiffusion

10 g der PBO-Vorstufe nach Beispiel 2 werden in 40 g destilliertem N-Methylpyrrolidon gelöst. Die Lösung wird mittels einer mit einem Vorfilter versehenen Plastikspritze auf ein Substrat in Form einer gereinigten und getrockneten Siliziumscheibe (Wafer) aufgetragen und in einer Schleuderapparatur (Typ ST 146, Convac) geschleudert. Der auf dem Substrat entstandene Film wird zunächst auf einer Heizplatte bei 120°C vorgetrocknet (1 min) und anschließend - für die Cyclisierung (auf dem Substrat) - in einem programmierbaren Laborofen ("Sirius Junior", LP-Thermtech AG) unter Stickstoff (Fluss: 1 l/min, Normaldruck) auf 350°C aufgeheizt und bei dieser Temperatur 1 h getempert, dann wird abgekühlt; die Aufheizund Abkühlgeschwindigkeit beträgt jeweils 5°C/min. Schichtdicke: 1,1 µm.
(a) In einer Sputteranlage (Z 550, Leybold Heraeus) wird Reinstaluminium (99,999 %) auf einem 4"-Siliziumwafer unter folgenden Prozessbedingungen abgeschieden: Targetgröße 3 Zoll, Substrat geerdet, Substrattemperatur 50°C, Leistung 500 W, Sputtergas Argon (50 sccm), Prozessdruck 3,8 µbar, Prozesszeit 10 min; die Dicke der abgeschiedenen Aluminiumschicht beträgt 0,6 µm. Anschließend wird, wie vorstehend beschrieben, auf der Aluminiumoberfläche eine 1 µm dicke Polybenzoxazol-Schicht erzeugt und bei 350°C ausgeheizt. Nach dem Abkühlen wird die Oberfläche mikroskopisch untersucht. Unter dem Lichtmikroskop zeigt sich dabei eine saubere Oberfläche des Polymers. Der Versuch wird bei Ausheiztemperaturen von 400°C und 450°C wiederholt. Hierbei wird ebenfalls eine saubere Oberfläche des Polymers beobachtet. Die darunter liegende Aluminiumschicht zeigt ebenfalls keine Veränderungen der Oberflächenbeschaffenheit.
(b) Auf einem Siliziumsubstrat wird, wie vorstehend beschrieben, ein 1,1 µm dicker Polybenzoxazol-Film erzeugt und bei 350°C ausgeheizt. Auf diesem Polymerfilm wird durch Sputtern unter den vorstehend genannten Prozessbedingungen eine 0,6 µm dicke Schicht aus Reinstaluminium abgeschieden. Die Haftung der Aluminiumschicht wird durch eine 5 s andauernde Sauerstoff-Plasmabehandlung (MIE 720, Material Research Corporation: Leistung 900 W, 30 sccm Sauerstoff) verbessert. Anschließend wird das Substrat in einem Laborofen 1 h auf 350°C erhitzt und dann abgekühlt; die Aufheiz- und die Abkühlgeschwindigkeit beträgt 5°C/min. Zur Beurteilung der diffusionsbedingten Clusterbildung wird die Aluminiumschicht durch Eintauchen in Salzsäure (ca. 10 %-ig) bei 40°C abgelöst. Unter dem Lichtmikroskop sind keine Oberflächenveränderungen der Polymerschicht festzustellen.
   Der Versuch wird bei Ausheiztemperaturen von 400°C und 450°C wiederholt. Hierbei wird ebenfalls keine Clusterbildung beobachtet.
(c) Dieselben Ergebnisse wie unter (a) und (b) beschrieben werden erhalten, wenn statt Reinstaluminium eine Legierung von Aluminium mit Kupfer und Silizium (AlCuSi) verwendet wird. Anstelle eines Reinstaluminium-Targets wird hierbei in der Sputteranlage ein AlCuSi-Target eingesetzt.

Dieselben Ergebnisse werden auch dann erhalten, wenn das Aluminium nicht gesputtert, sondern aufgedampft wird.

### Beispiel 4

### Photostrukturierung

4 g der PBO-Vorstufe nach Beispiel 2 werden zusammen mit 1 g eines Diesters aus Bisphenol A und Naphthochinondiazid-5-sulfonsäure (photoaktive Komponente) in 15 g N-Methylpyrrolidon gelöst. Diese Photoresistlösung wird mittels einer mit einem Vorfilter versehenen Plastikspritze auf ein Substrat in Form einer gereinigten und getrockneten Siliziumscheibe (Wafer) aufgetragen und in einer Schleuderapparatur (Typ ST 146, Convac) geschleudert. Der auf dem Substrat entstandene Resistfilm wird zunächst auf einer Heizplatte bei 120°C vorgetrocknet und anschließend in einer Belichtungsapparatur (Typ 121, Karl Süss) durch eine Maske belichtet. Nach der Entwicklung mit einem wässrig-alkalischen Entwickler (NMD-W, Tokyo Ohka, 1:1 mit Wasser verdünnt) und der Cyclisierung (auf dem Substrat) bei 350°C entsprechend Beispiel 3 werden hochtemperaturstabile Resiststrukturen erhalten.

### Beispiel 5

### Bestimmung der Aluminiumdiffusion

Mit einer Photoresistlösung entsprechend Beispiel 4 erfolgt - entsprechend Beispiel 3 - eine Bestimmung der Aluminiumdiffusion. Hierbei werden dieselben Ergebnisse erhalten wie mit der Lösung der PBO-Vorstufe.

### Beispiel 6

### Bestimmung der Aluminiumdiffusion (Vergleichsversuch)

Die Bestimmung erfolgt entsprechend Beispiel 3 unter Verwendung einer PBO-Vorstufe aus 3,3'-Dihydroxy-benzidin und Isophthalsäuredichlorid (siehe dazu EP-PS 0 023 662: Beispiel 1; ohne photoaktive Komponente). Nach der Temperung entsprechend 3(a) ist eindeutig ersichtlich, dass Aluminium durch das Polymer (Polybenzoxazol) an die Polymeroberfläche diffundiert ist. Unter einem Lichtmikroskop sind nicht nur kleine Partikel, sondern auch größere Aluminiumcluster (Hillocks) zu erkennen. Dabei wird bei einer Ausheiztemperatur von 350°C eine mäßige Aluminiumdiffusion beobachtet, bei 400°C eine deutliche und 450°C eine starke Diffusion.

Bei einer Versuchsführung entsprechend 3(b) wird festgestellt, dass die Polymeroberfläche nach dem Ablösen des Aluminiums sehr rau ist und zahlreiche "Löcher" im Mikrometerbereich aufweist. Dies ist ein sicherer Hinweis auf eine Aluminiumdiffusion.

Dieselben Ergebnisse werden erhalten, wenn die PBO-Vorstufe zusammen mit einer photoaktiven Komponente eingesetzt wird (siehe EP-PS 0 023 662).

### Beispiel 7

### Bestimmung der Aluminiumdiffusion (Vergleichsversuch)

Die Bestimmung erfolgt entsprechend Beispiel 3 bzw. Beispiel 6 unter Verwendung einer PBO-Vorstufe aus Hexafluor-2,2-bis-(3-amino-4-hydroxy-phenyl)-propan, Isophthalsäuredichlorid und Terephthalsäuredichlorid (siehe dazu EP-PS 0 264 678: Beispiel 1). Die Ergebnisse sind dieselben wie bei Beispiel 6, d.h. Aluminium diffundiert durch das Polymer.

### Beispiel 8

### Herstellung einer PBO-Vorstufe und Bestimmung der Eigenschaften

Analog zu Beispiel 2 wird eine PBO-Vorstufe hergestellt, wobei - unter sonst gleichen Bedingungen - als Dicarbonsäuredichlorid Isophthalsäuredichlorid (0,1 mol, d.h. 20,3 g) eingesetzt wird.

Die erhaltene PBO-Vorstufe ist in den in Beispiel 2 aufgeführten Lösemitteln gut löslich. Eine Photostrukturierung entsprechend Beispiel 4 ergibt, dass ein mittels dieser Vorstufe hergestelltes Resistmaterial gut strukturierbar ist. Untersuchungen bezüglich der Aluminiumdiffusion entsprechend Beispiel 3 bzw. Beispiel 5 liefern dieselben Ergebnisse wie diese Beispiele.

### Beispiel 9

### Herstellung einer PBO-Vorstufe und Bestimmung der Eigenschaften

Analog zu Beispiel 2 wird eine PBO-Vorstufe hergestellt, wobei - unter sonst gleichen Bedingungen - als Dicarbonsäuredichlorid p-Phenylen-β,β-diacrylsäuredichlorid (0,1 mol, d.h. 25,5 g) eingesetzt wird.

Die erhaltene PBO-Vorstufe ist in den in Beispiel 2 aufgeführten Lösemitteln gut löslich. Eine Photostrukturierung entsprechend Beispiel 4 ergibt, dass ein mittels dieser Vorstufe hergestelltes Resistmaterial gut strukturierbar ist. Untersuchungen bezüglich der Aluminiumdiffusion entsprechend Beispiel 3 bzw. Beispiel 5 liefern dieselben Ergebnisse wie diese Beispiele.

### Beispiel 10

### Herstellung einer PBO-Vorstufe und Bestimmung der Eigenschaften

Analog zu Beispiel 2 wird eine PBO-Vorstufe hergestellt, wobei - unter sonst gleichen Bedingungen - als Dicarbonsäuredichlorid Diphenylether-4,4'-dicarbonsäuredichlorid (0,1 mol, d.h. 29,51 g) eingesetzt wird.

Die erhaltene PBO-Vorstufe ist in den in Beispiel 2 aufgeführten Lösemitteln gut löslich. Eine Photostrukturierung entsprechend Beispiel 4 ergibt, dass ein mittels dieser Vorstufe hergestelltes Resistmaterial gut strukturierbar ist. Untersuchungen bezüglich der Aluminiumdiffusion entsprechend Beispiel 3 bzw. Beispiel 5 liefern dieselben Ergebnisse wie diese Beispiele.

### Beispiel 11

### Herstellung einer PBO-Vorstufe und Bestimmung der Eigenschaften

Die in Beispiel 10 beschriebene PBO-Vorstufe ist auch auf chloridfreiem Weg herstellbar. Dazu werden 25,82 g Diphenylether-4,4'-dicarbonsäure (0,1 mol) in 200 ml N-Methylpyrrolidon gelöst und portionsweise mit 34,1 g Carbonyldiimidazol (0,21 mol) versetzt. Nachdem die Gasentwicklung (CO₂) abgeklungen ist, wird noch 2 h gerührt. Die erhaltene Suspension wird dann zu 56,46 g 9,9-Bis(4-[(4-amino-3-hydroxy)-phenoxy]-phenyl}-fluoren (0,1 mol), gelöst in 300 ml N-Methylpyrrolidon, gegeben und 40 h bei Raumtemperatur gerührt; hierbei klärt sich die Reaktionslösung wieder. Die Fällung und die Trocknung der PBO-Vorstufe erfolgt wie in Beispiel 2.

Die erhaltene PBO-Vorstufe ist in den in Beispiel 2 aufgeführten Lösemitteln gut löslich. Eine Photostrukturierung entsprechend Beispiel 4 ergibt, dass ein mittels dieser Vorstufe hergestelltes Resistmaterial gut strukturierbar ist. Untersuchungen bezüglich der Aluminiumdiffusion entsprechend Beispiel 3 bzw. Beispiel 5 liefern dieselben Ergebnisse wie diese Beispiele.

### Beispiel 12

### Herstellung einer PBO-Vorstufe und Bestimmung der Eigenschaften

Analog zu Beispiel 2 wird eine PBO-Vorstufe hergestellt, wobei - unter sonst gleichen Bedingungen - als Bis-o-aminophenol 9,10-Bis{4-[(4-amino-3-hydroxy)-phenoxy]-phenyl}anthracen (0,1 mol, d.h. 57,67 g) und als Dicarbonsäuredichlorid Isophthalsäuredichlorid (0,1 mol, d.h. 20,3 g) eingesetzt wird. Das Bis-o-aminophenol wird - analog Beispiel 1 - aus 9,10-Bis(4-hydroxy-phenyl)-anthracen und 3-Fluor-6-nitro-benzyloxy-phenol hergestellt.

Die erhaltene PBO-Vorstufe ist in den in Beispiel 2 aufgeführten Lösemitteln gut löslich. Eine Photostrukturierung entsprechend Beispiel 4 ergibt, dass ein mittels dieser Vorstufe hergestelltes Resistmaterial gut strukturierbar ist. Untersuchungen bezüglich der Aluminiumdiffusion entsprechend Beispiel 3 bzw. Beispiel 5 liefern dieselben Ergebnisse wie diese Beispiele.

### Beispiel 13

### Herstellung einer PBO-Vorstufe und Bestimmung der Eigenschaften

Analog zu Beispiel 2 wird eine PBO-Vorstufe hergestellt, wobei - unter sonst gleichen Bedingungen - als Bis-o-aminophenol 6,6'-Bis[(4-amino-3-hydroxy)-phenoxy]-5,5'-dimethyl-3,3,3',3'-tetramethyl-1,1'-spiro-bis(indan) (0,1 mol, d.h.

55,07 g) und als Dicarbonsäuredichlorid Terephthalsäuredichlorid (0,1 mol, d.h. 20,3 g) eingesetzt wird. Das Bis-o-aminophenol wird - analog Beispiel 1 - aus 6,6'-Dihydroxy-5,5'-dimethyl-3,3,3',3'-tetramethyl-1,1'-spiro-bis (indan) und 3-Fluor-6-nitro-benzyloxy-phenol hergestellt.

Die erhaltene PBO-Vorstufe ist in den in Beispiel 2 aufgeführten Lösemitteln gut löslich. Eine Photostrukturierung entsprechend Beispiel 4 ergibt, dass ein mittels dieser Vorstufe hergestelltes Resistmaterial gut strukturierbar ist. Untersuchungen bezüglich der Aluminiumdiffusion entsprechend Beispiel 3 bzw. Beispiel 5 liefern dieselben Ergebnisse wie diese Beispiele.

### Beispiel 14

### Herstellung einer PBO-Vorstufe und Bestimmung der Eigenschaften

Analog zu Beispiel 2 wird eine PBO-Vorstufe hergestellt, wobei - unter sonst gleichen Bedingungen - als Bis-o-aminophenol 4,7-Bis[(4-amino-3-hydroxy)-phenoxy]-1,10-phenanthrolin (0,1 mol, d.h. 42,64 g) und als Dicarbonsäuredichlorid Diphenylether-4,4'-dicarbonsäuredichlorid (0,1 mol, d.h. 29,51 g) eingesetzt wird. Das Bis-o-aminophenol wird - analog Beispiel 1 - aus 4,7-Dihydroxy-1,10-phenanthrolin und 3-Fluor-6-nitro-benzyloxy-phenol hergestellt.

Die erhaltene PBO-Vorstufe ist in den in Beispiel 2 aufgeführten Lösemitteln gut löslich. Eine Photostrukturierung entsprechend Beispiel 4 ergibt, dass ein mittels dieser Vorstufe hergestelltes Resistmaterial gut strukturierbar ist. Untersuchungen bezüglich der Aluminiumdiffusion entsprechend Beispiel 3 bzw. Beispiel 5 liefern dieselben Ergebnisse wie diese Beispiele.

### Beispiel 15

### Herstellung einer o-Aminophenolcarbonsäure: 9-{4-[(4-Amino-3-hydroxy)-phenoxy]-phenyl}-9-{4-[(2-trifluormethyl-4-carboxy)-phenoxy]-phenyl}-fluoren

50,0 g 9,9-Bis(4-hydroxy-phenyl)-fluoren (0,143 mol) und 35,28 g 3-Fluor-6-nitro-benzyloxy-phenol (0,143 mol) werden in 550 ml Dimethylformamid gelöst. Anschließend wird mit 100,0 g K₂CO₃ (0,724 mol) versetzt und unter ständigem Rühren 5 h auf 120°C erhitzt. Nach Beendigung der Reaktion wird auf Raumtemperatur abgekühlt und die Mischung unter Rühren in 1,0 1 Eiswasser gegossen. Der dabei ausfallende gelbe Feststoff wird über einen Büchnertrichter abfiltriert, je einmal mit verdünntem Eisessig und Wasser gewaschen und anschließend in einem Vakuumschrank unter Stickstoff bei 50°C/50 mbar getrocknet.

Die Reinigung des Rohproduktes durch Umkristallisieren erfolgt entsprechend Beispiel 1 mit 350 ml Tetrahydrofuran und 350 ml Petroleumbenzin.

50,0 g des auf diese Weise hergestellten 9-{4-[(3-Benzyloxy-4-nitro)-phenoxy]-phenyl}-9-(4-hydroxy-phenyl)-fluoren (0,0866 mol) und 25,83 g 4-Fluor-3-trifluormethyl-benzoesäurebenzylester (0,0866 mol) werden in 400 ml Dimethylformamid gelöst. Anschließend wird mit 31,40 g K₂CO₃ (0,2272 mol) versetzt und unter ständigem Rühren 3 h auf 135°C erhitzt. Nach Beendigung der Reaktion wird auf Raumtemperatur abgekühlt, die Mischung über ein Faltenfilter abfitriert und in 1 l Wasser gegossen; dann wird 3 mal mit insgesamt 600 ml Essigester extrahiert. Die vereinigten organischen Phasen werden noch 2 mal mit Wasser gewaschen, und die erhaltene farblose Lösung wird am Rotationsverdampfer bis zur Trockene eingedampft; dabei wird ein weißer Feststoff erhalten.

Die Reinigung des Rohproduktes durch Umkristallisieren erfolgt entsprechend Beispiel 1 mit 350 ml Tetrahydrofuran und 350 ml Petroleumbenzin.

50,0 g des auf diese Weise hergestellten 9-{4-[(3-Benzyloxy-4-nitro)-phenoxy]-phenyl}-9-{4-[(2-trifluormethyl-4-benzylcarboxy)-phenoxy]-phenyl}-fluoren (0,058 mol) werden in 700 ml Tetrahydrofuran gelöst, die Lösung wird mit 5,0 g Palladium auf Aktivkohle versetzt und die Suspension in einem Autoklaven bei Raumtemperatur mit Wasserstoff bei einem Druck von 2 bar hydriert; die Reaktion ist nach 24 h beendet. Die Suspension wird dann über einen Büchnertrichter abfiltriert. Von der dabei erhaltenen hellbraunen Lösung wird mittels eines Rotationsverdampfers das Lösemittel vollständig entfernt.

Die Reinigung des Rohproduktes durch Umkristallisieren erfolgt entsprechend Beispiel 1 mit 350 ml Tetrahydrofuran und 100 ml Petroleumbenzin.

### Beispiel 16

### Herstellung einer PBO-Vorstufe und Bestimmung der Eigenschaften

64,56 g entsprechend Beispiel 15 hergestelltes 9-{4-[(4-Amino-3-hydroxy)-phenoxy]-phenyl}-9-{4-[(2-trifluormethyl-4-carboxy)-phenoxy]-phenyl}-fluoren (0,1 mol), werden in 350 ml destilliertem N-Methylpyrrolidon gelöst. Zu dieser Lösung tropft man bei 0°C langsam eine Lösung von 13 g Oxalylchlorid (0,102 mol) in 80 ml γ-Butyrolacton. Nach der Zugabe wird noch 2 h bei 0°C und 18 h bei Raumtemperatur (23°C) gerührt. Anschließend gibt man - zur vollständigen Umsetzung - bei 0°C eine Lösung von 20 ml Pyridin in 100 ml N-Methylpyrrolidon hinzu und rührt weitere 24 h bei Raumtemperatur (23°C). Die Lösung wird dann über einen Büchnertrichter filtriert und unter starkem Rühren zu einem Gemisch von Isopropanol und Wasser (1:3) getropft. Die Menge des Fällungsmittels (Isopropanaol/Wasser) wird dabei so gewählt, daß sie dem 10-fachen der Reaktionslöung entspricht. Das ausgefallene Polymer wird über einen Büchnertrichter abfiltriert und dreimal mit einer 1 %igen Ammoniaklösung gewaschen. Nachfolgend wird das Polymer in einem Vakuumschrank 72 h unter Stickstoff bei 40°C/10 mbar getrocknet.

Die erhaltene PBO-Vorstufe ist in den in Beispiel 2 aufgeführten Lösemitteln gut löslich. Eine Photostrukturierung entsprechend Beispiel 4 ergibt, dass ein mittels dieser Vorstufe hergestelltes Resistmaterial gut strukturierbar ist. Untersuchungen bezüglich der Aluminiumdiffusion entsprechend Beispiel 3 bzw. Beispiel 5 liefern dieselben Ergebnisse wie diese Beispiele.

### Beispiel 17

### Herstellung einer PBO-Vorstufe und Bestimmung der Eigenschaften

Analog zu Beispiel 16 wird eine PBO-Vorstufe hergestellt, wobei - unter sonst gleichen Bedingungen - als o-Aminophenolcarbonsäure 9-{4-[(4-Amino-3-hydroxy)-phenoxy]-phenyl}-10-{4-[(4-carboxy)-phenoxy]-pheny}-anthracen (0,1 mol, d.h. 58,96 g) eingesetzt wird. Die o-Aminophenolcarbonsäure wird - analog Beispiel 15 - aus 9,10-Bis(4-hydroxy-phenyl)-anthracen und 3-Fluor-6-nitro-benzyloxy-phenol sowie 4-Fluor-benzoesäurebenzylester hergestellt.

Die erhaltene PBO-Vorstufe ist in den in Beispiel 2 aufgeführten Lösemitteln gut löslich. Eine Photostrukturierung entsprechend Beispiel 4 ergibt, dass ein mittels dieser Vorstufe hergestelltes Resistmaterial gut strukturierbar ist. Untersuchungen bezüglich der Aluminiumdiffusion entsprechend Beispiel 3 bzw. Beispiel 5 liefern dieselben Ergebnisse wie diese Beispiele.

### Beispiel 18

### Herstellung einer PBO-Vorstufe und Bestimmung der Eigenschaften

Analog zu Beispiel 16 wird eine PBO-Vorstufe hergestellt, wobei - unter sonst gleichen Bedingungen - als o-Aminophenolcarbonsäure 6-[(4-Amino-3-hydroxy)-phenoxy]-6'-[(4-carboxy)-phenoxy]-5,5'-dimethyl-3,3,3',3'-tetramethyl-1,1'-spirobis(indan) (0,1 mol, d.h. 56,37 g) eingesetzt wird. Die o-Aminophenolcarbonsäure wird - analog Beispiel 15 - aus 6,6'-Dihydroxy-5,5'-dimethyl-3, 3,3',3'-tetramethyl-1,1'spiro-bis(indan) und 3-Fluor-6-nitro-benzyloxy-phenol sowie 4-Fluor-benzoesäurebenzylester hergestellt.

Die erhaltene PBO-Vorstufe ist in den in Beispiel 2 aufgeführten Lösemitteln gut löslich. Eine Photostrukturierung entsprechend Beispiel 4 ergibt, dass ein mittels dieser Vorstufe hergestelltes Resistmaterial gut strukturierbar ist. Untersuchungen bezüglich der Aluminiumdiffusion entsprechend Beispiel 3 bzw. Beispiel 5 liefern dieselben Ergebnisse wie diese Beispiele.

### Beispiel 19

### Herstellung einer PBO-Vorstufe und Bestimmung der Eigenschaften

Analog zu Beispiel 16 wird eine PBO-Vorstufe hergestellt, wobei - unter sonst gleichen Bedingungen - als o-Aminophenolcarbonsäure 4-[(4-Amino-3-hydroxy)-phenoxy]-7-[(4-carboxy)-phenoxy]-1,10-phenanthrolin (0,1 mol, d.h. 43,94 g) eingesetzt wird. Die o-Aminophenolcarbonsäure wird - analog Beispiel 15 - aus 4,7-Dihydroxy-1,10-phenanthrolin und 3-Fluor-6-nitro-benzyloxy-phenol sowie 4-Fluor-benzoesäurebenzylester hergestellt.

Die erhaltene PBO-Vorstufe ist in den in Beispiel 2 aufgeführten Lösemitteln gut löslich. Eine Photostrukturierung entsprechend Beispiel 4 ergibt, dass ein mittels dieser Vorstufe hergestelltes Resistmaterial gut strukturierbar ist. Untersuchungen bezüglich der Aluminiumdiffusion entsprechend Beispiel 3 bzw. Beispiel 5 liefern dieselben Ergebnisse wie diese Beispiele.

### Beispiel 20

### Herstellung einer PBO-Vorstufe und Bestimmung der Eigenschaften

56,46 g entsprechend Beispiel 1 hergestelltes 9,9-Bis-{4-[(4-amino-3-hydroxy)-phenoxy]-phenyl }-fluoren (0,1 mol) werden in 300 ml destilliertem N-Methylpyrrolidon gelöst. Zu dieser Lösung wird bei 10°C unter Rühren eine Lösung von 18,27 g Terephthalsäuredichlorid (0,09 mol) in 135 ml γ-Butyrolacton getropft und die Reaktionslösung 16 h gerührt. Danach wird - zur Blockierung der Endgruppen - bei 10°C unter Rühren eine Lösung von 4,81 g 4-(Phenylethinyl)-benzoesäurechlorid (0,02 mol) in 30 ml γ-Butyrolacton zugetropft und die Reaktionslösung 16 h gerührt. Nachfolgend wird bei Raumtemperatur langsam eine Lösung von 17,4 g Pyridin (0,22 mol) in 80 ml γ-Butyrolacton zugetropft und die erhaltene Reaktionslösung 2 h bei Raumtemperatur gerührt. Das entstandene Polymer wird durch Zutropfen der Reaktionslösung zu einem Gemisch von Isopropanol und Wasser (1:3) ausgefällt, dreimal mit frischem Fällungsmittel gewaschen und in einem Vakuumofen 72 h bei 50°C/10 mbar getrocknet.

Die erhaltene PBO-Vorstufe ist in den in Beispiel 2 aufgeführten Lösemitteln gut löslich. Eine Photostrukturierung entsprechend Beispiel 4 ergibt, dass ein mittels dieser Vorstufe hergestelltes Resistmaterial gut strukturierbar ist. Untersuchungen bezüglich der Aluminiumdiffusion entsprechend Beispiel 3 bzw. Beispiel 5 liefern dieselben Ergebnisse wie diese Beispiele.

## Patentansprüche

1. Polybenzoxazol-Vorstufen, **gekennzeichnet durch** eine der folgenden Partialstrukturen: 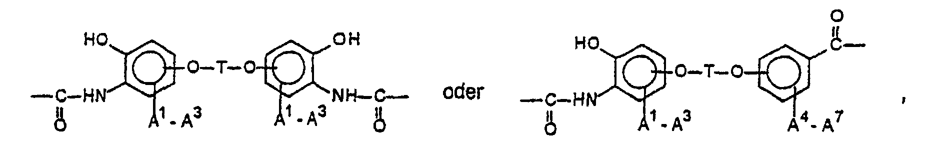 wobei Folgendes gilt:
A¹ bis A⁷ sind - unabhängig voneinander - H, F, CH₃, CF₃, OCH₃ oder OCF₃;
T ist einer der folgenden Reste: 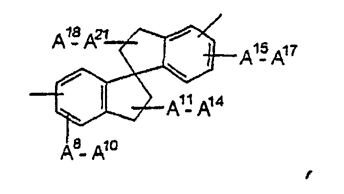 wobei A⁸ bis A²¹ - unabhängig voneinander - H, F, CH₃, CF₃, OCH₃ oder OCF₃ sind; 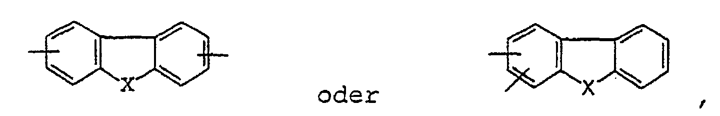 wobei X die Bedeutung CH₂, CF₂, C(CH₃)₂, C(CF₃)₂, C(OCH₃)₂, C(OCF₃)₂, C(CH₃) (C₆H₅), C(C₆H₅)₂, O, N-H, N-CH₃ oder N-C₆H₅ hat; 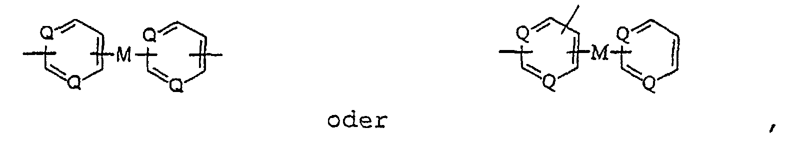 mit M = 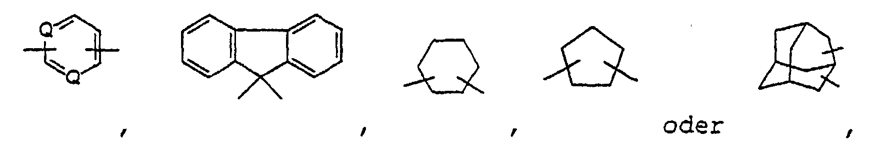 wobei Q jeweils C-H, C-F, C-CH₃, C-CF₃, C-OCH₃, C-OCF₃ oder N ist;
T und M können - unabhängig voneinander - auch einer der folgenden Reste sein: 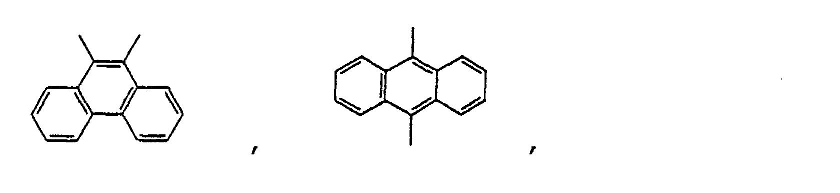 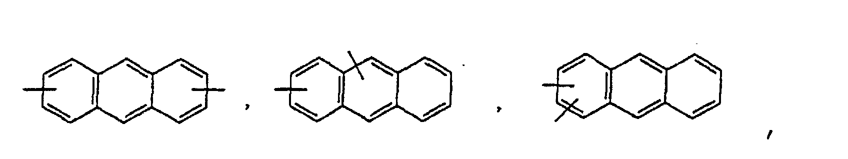 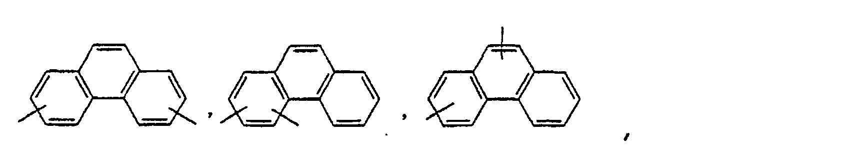 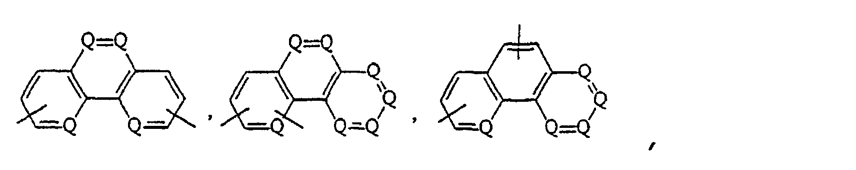 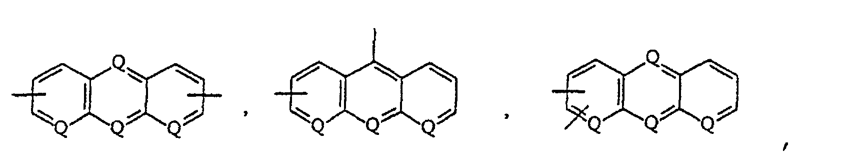 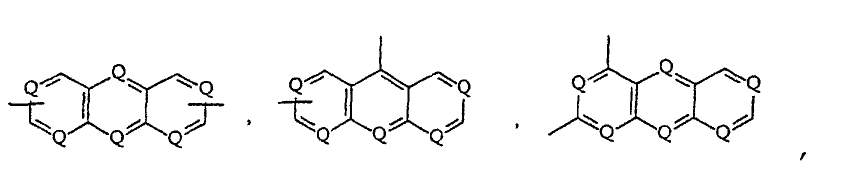 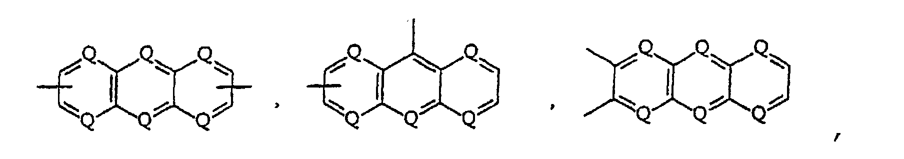 wobei Q wie vorstehend definiert ist, mindestens ein Q die Bedeutung N hat und maximal zwei N-Atome pro Ring vorhanden sein dürfen.

2. Polybenzoxazol-Vorstufen nach Anspruch 1, **dadurch gekennzeichnet, dass** sie in der Hauptkette, als Endgruppe oder als Seitengruppe Acetylengruppen enthalten.

3. Polybenzoxazol-Vorstufen nach Anspruch 2, **dadurch gekennzeichnet, dass** den Acetylengruppen eine der folgenden Verbindungen zugrunde liegt:

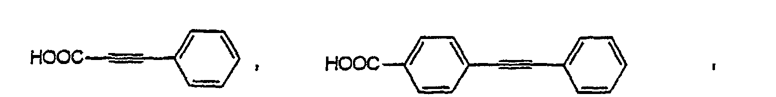

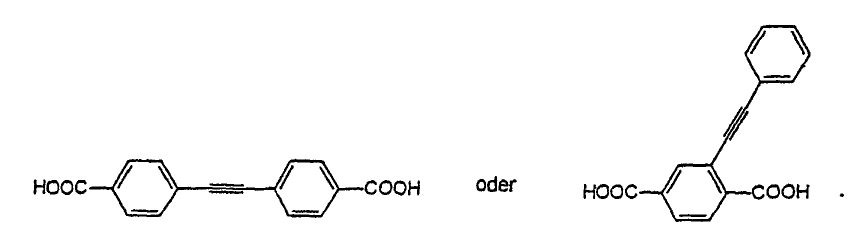

4. Photoresistlösungen, **dadurch gekennzeichnet, dass** sie eine Polybenzoxazol-Vorstufe nach einem der Ansprüch 1 bis 3 und ein Diazoketon als photoaktive Komponente, gelöst in einem organischen Lösemittel, enthalten.

5. Photoresistlösungen nach Anspruch 4, **dadurch gekennzeichnet, dass** das Gewichtsverhältnis von Polybenzoxazol-Vorstufe zu Diazochinon zwischen 1:20 und 20:1 liegt, vorzugsweise zwischen 1:10 und 10:1.

6. Polybenzoxazole, **gekennzeichnet durch** eine der folgenden Partialstrukturen: 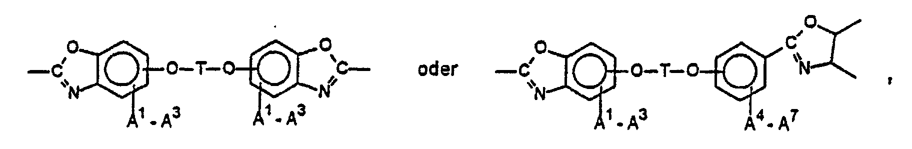 wobei A¹ bis A⁷ und T die vorstehend angegebene Bedeutung haben.

## Claims

1. Polybenzoxazole precursors, **characterized by** one of the following partial structures: 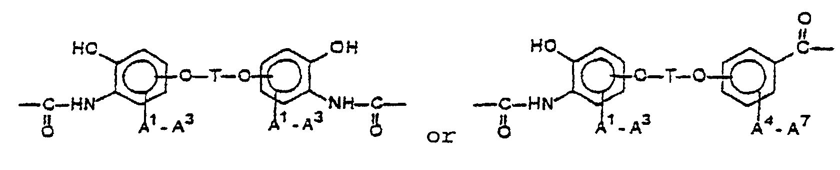 where the following is applicable:
A¹ to A⁷ - independently of one another - are H, F, CH₃, CF₃, OCH₃ or OCF₃;
T is one of the following radicals: 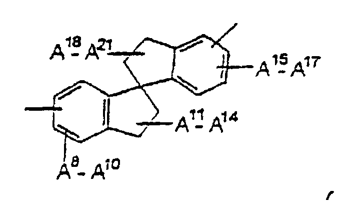 where A⁸ to A²¹ - independently of one another - are H, F, CH₃, CF₃, OCH₃ or OCF₃; 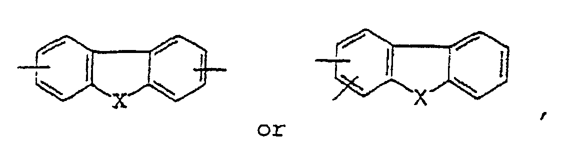 where X denotes CH₂, CF₂, C(CH₃)₂, C(CF₃)₂, C(OCH₃)₂, C(OCF₃)₂, C(CH₃)(C₆H₅), C(C₆H₅)₂, O, N-H, N-CH₃ or N-C₆H₅; 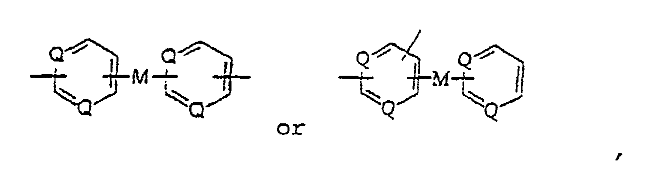 where M = 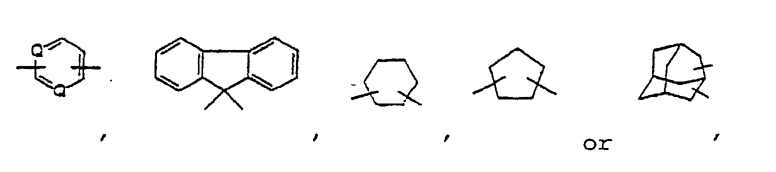 where Q in each case is C-H, C-F, C-CH₃, C-CF₃, C-OCH₃, C-OCF₃ or N;
T and M - independently of one another - may also be one of the following radicals: 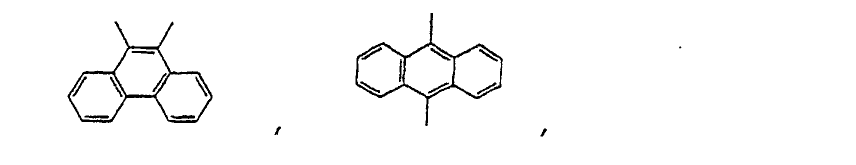 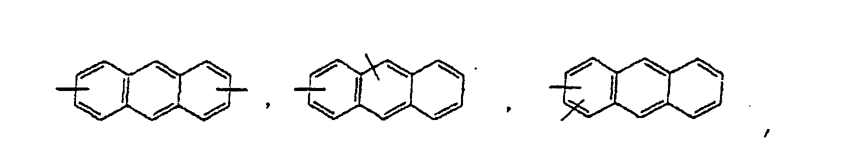 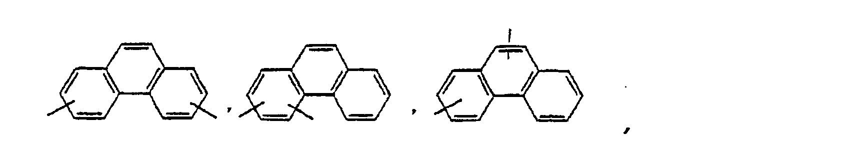 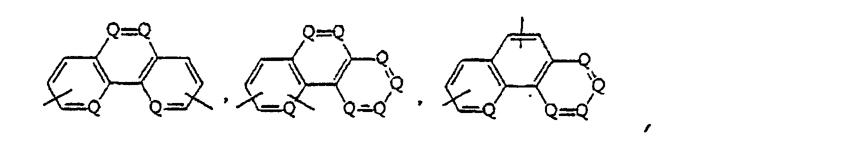 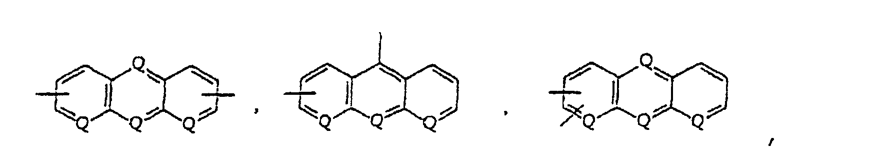 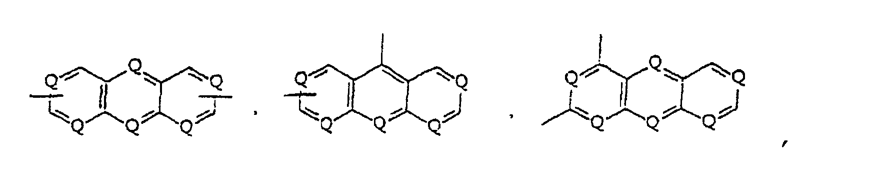 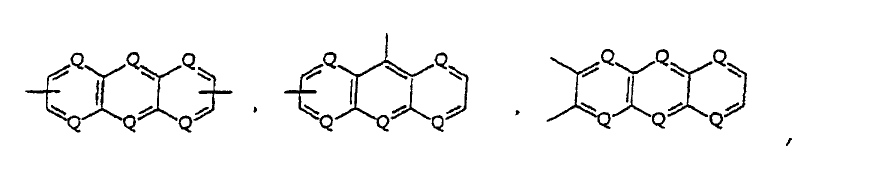 where Q is defined as above, at least one Q denotes N and not more than two N atoms may be present per ring.

2. Polybenzoxazole precursors according to Claim 1, **characterized in that** they contain acetylene groups in the main chain, as a terminal group or as a side group.

3. Polybenzoxazole precursors according to Claim 2, **characterized in that** the acetylene groups are based on one of the following compounds:

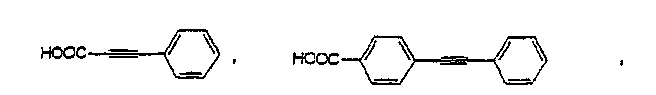

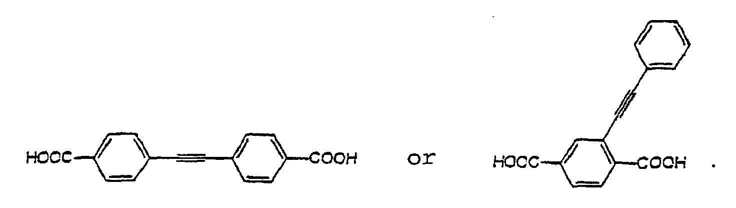

4. Photoresist solutions, **characterized in that** they contain a polybenzoxazole precursor according to any of Claims 1 to 3 and a diazo ketone as a photoactive component, dissolved in an organic solvent.

5. Photoresist solutions according to Claim 4, **characterized in that** the weight ratio of polybenzoxazole precursor to diazoquinone is from 1:20 to 20:1, preferably from 1:10 to 10:1.

6. Polybenzoxazoles, **characterized by** one of the following partial structures: 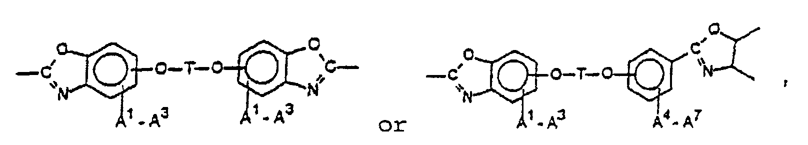 where A¹ to A⁷ and T have the abovementioned meaning.

## Revendications

1. Précurseur de polybenzoxazole, **caractérisé par** l'une des structures partielles suivantes : 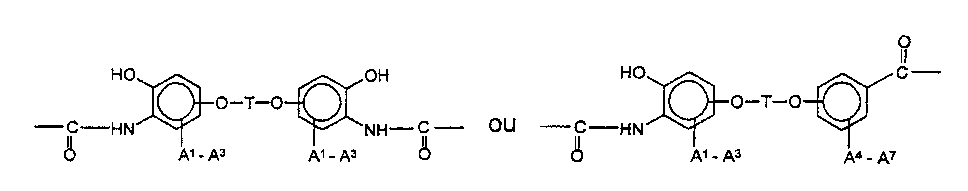 dans lesquelles :
A¹ à A⁷ sont indépendamment les uns des autres H, F, CH₃, CF₃, OCH₃ ou OCF₃ ;
T est l'un des radicaux suivants : 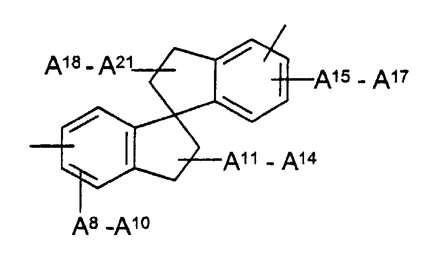 dans laquelle A⁸ à A²¹ sont indépendamment les uns des autres H, F, CH₃, CF₃, OCH₃ ou OCF₃ ; 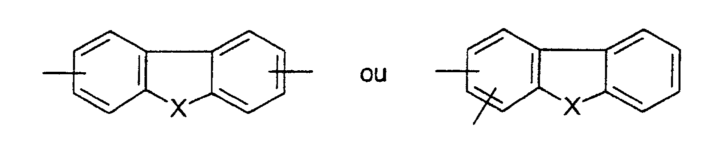 dans lesquelles X a la signification CH₂, CF₂, C(CH₃)₂, C(CF₃)₂, C(OCH₃)₂, C(OCF₃)₂, C(CH₃) (C₆H₅), (C₆H₅)₂, O, N-H, N-CH₃ ou N-C₆H₅ ; 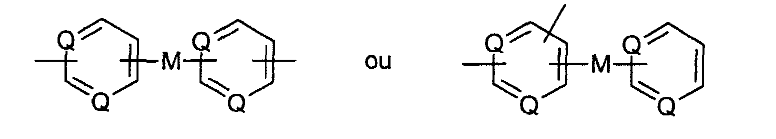 avec M = 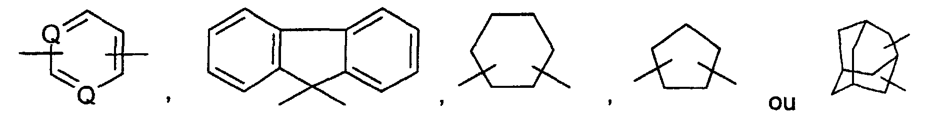 dans lesquelles Q est respectivement C-H, C-F, C-H₃, C-CF₃, C-OCH₃, C-OCF₃, ou N ;
T et M peuvent indépendamment l'un de l'autre être également l'un des radicaux suivants : 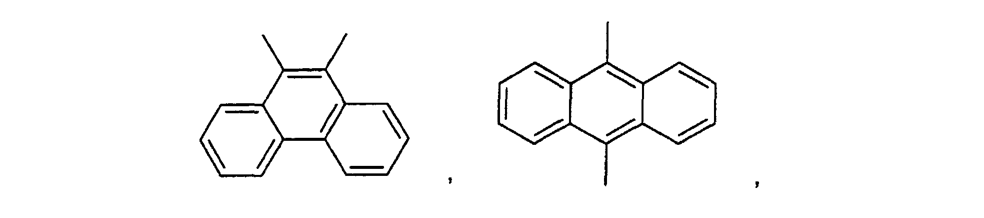 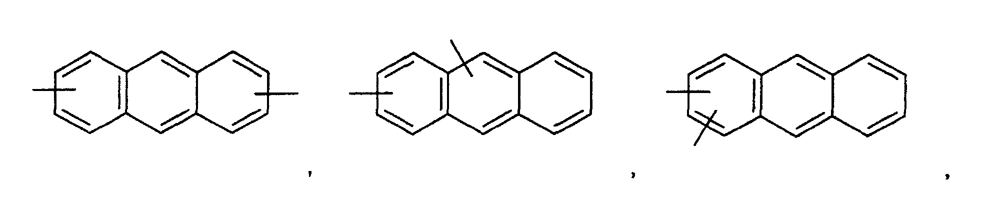 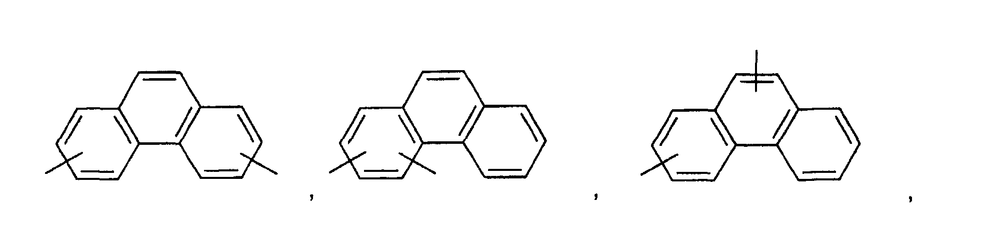 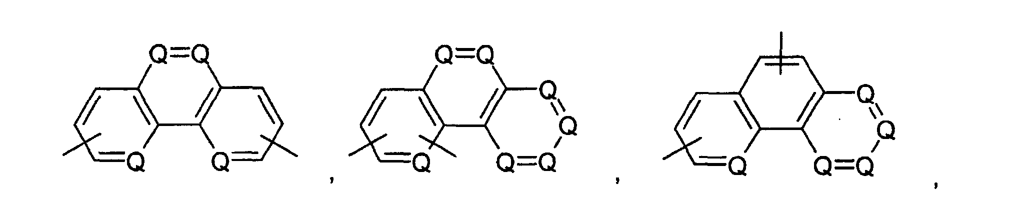 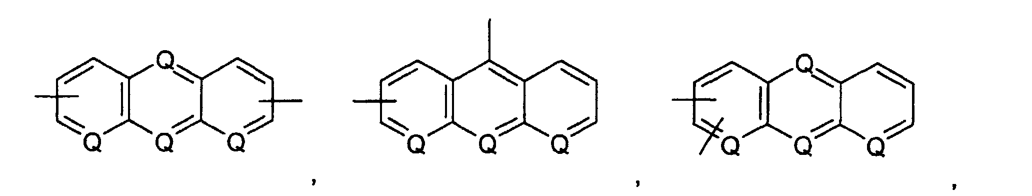 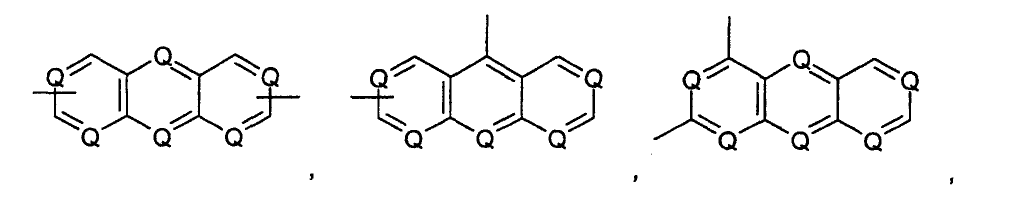 dans lesquelles Q est défini comme ci-dessus, au moins un Q a la signification N, et il peut y avoir au maximum deux atomes d'azote par cycle.

2. Précurseurs de polybenzoxazole suivant la revendication 1, **caractérisés en ce qu'**ils contiennent, dans la chaîne principale, comme groupe d'extrémité ou comme groupe latéral des groupes acétylène.

3. Précurseur de polybenzoxazole suivant la revendication 2, **caractérisés en ce qu'**à la base des groupes acétylène se trouve l'un des composés suivants :

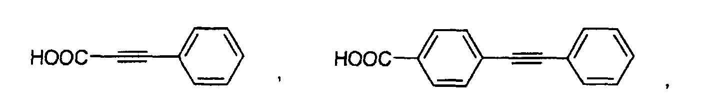

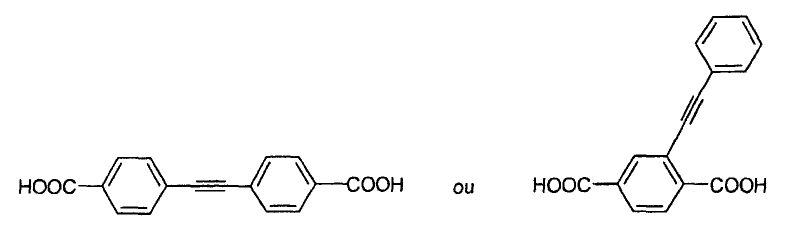

4. Solutions de photoréserve, **caractérisées en ce qu'**elles contiennent un précurseur de polybenzoxazole suivant l'une des revendications 1 à 3 et une diazocétone comme constituant photoactif dissous dans un solvant organique.

5. Solutions de photoréserve suivant la revendication 4, **caractérisées en ce que** le rapport en poids du précurseur de polybenzoxazole à la diazoquinone est compris entre 1:20 et 20:1 et de préférence entre 1:10 et 10:1.

6. Polybenzoxazole, **caractérisé par** l'une des structures partielles suivantes : 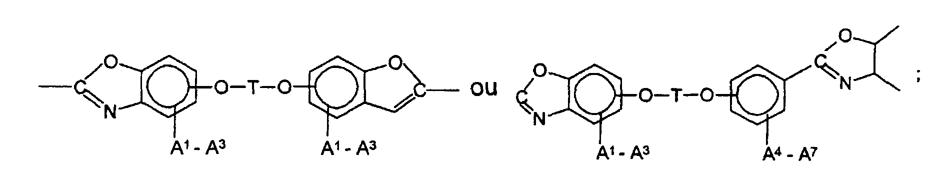 dans lesquelles A¹ à A⁷ et T ont la signification mentionnée ci-dessus.
